(19) Europäisches Patentamt
European Patent Office
Office européen des brevets

(11) EP 0 674 019 B1

# (12) EUROPEAN PATENT SPECIFICATION

(45) Date of publication and mention of the grant of the patent:
**02.06.1999 Bulletin 1999/22**

(51) Int Cl.[6]: **C23C 18/12**, H01L 21/316, H01L 21/3205

(21) Application number: **95103656.5**

(22) Date of filing: **14.03.1995**

## (54) Semiconductor devices and their method of manufacture

Halbleitervorrichtungen sowie deren Herstellungsverfahren

Dispositifs semi-conducteurs et leurs procédés de fabrication

(84) Designated Contracting States:
**DE FR GB IT NL**

(30) Priority: **14.03.1994 JP 69114/94**

(43) Date of publication of application:
**27.09.1995 Bulletin 1995/39**

(73) Proprietors:
- **TEXAS INSTRUMENTS INCORPORATED**
  **Dallas Texas 75265 (US)**
- **Tri-Chemical Lab, Inc.**
  **Aiko-gun, Kanagawa-ken (JP)**

(72) Inventors:
- **Aoki, Katsuhiro**
  **Tsukuba-shi, Ibaraki-ken, 305 (JP)**
- **Numata, Ken**
  **Inashiki-gun, 300-04 (JP)**
- **Fukuda, Yukio**
  **Naka-gun, Ibaraki-ken 319-11 (JP)**
- **Nishimura, Akitoshi**
  **Tsuchiura-shi, Ibaraki-ken 300 (JP)**
- **Nagao, Tomomi**
  **Kanagawa-ken, 243-03 (JP)**
- **Hachiya, Shinichi**
  **Kanagawa-ken, 229 (JP)**
- **Takamatsu, Yukichi**
  **Kanagawa-ken, 229 (JP)**

(74) Representative:
**Schwepfinger, Karl-Heinz, Dipl.-Ing.**
**Prinz & Partner GbR**
**Manzingerweg 7**
**81241 München (DE)**

(56) References cited:
**US-A- 4 946 710**

- **THIRD EURO-CERAMICS, vol.2, 12 September 1993, SPAIN pages 735 - 738 PAJEWSKI 'pzt coatings prepared by the sol-gel process on metallic substrates (al)'**
- **JOURNAL OF THE ELECTROCHEMICAL SOCIETY, vol.140, no.9, September 1993, USA pages 2640 - 2645 VIJAY 'ELECTRODES FOR PZT FERROELECTRIC THIN FILMS'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 674 019 B1

## Description

Industrial application field

This invention is concerned with a method for forming a ferroelectric film (in particular, a lead zirconate titanate (PZT) film) by the sol gel method, a method to manufacture a capacitor (in particular, a capacitor in a semiconductor memory cell), a method to prepare its source solution, and the source solution.

Conventional technology

An ONO film that is structured to have successively laminated $SiO_2$, $Si_3N_4$, and $SiO_2$ is used as an insulating film (dielectric film) that makes up a capacitor for memory cells in a dynamic RAM, for example.

However, the effective dielectric constant of said ONO film is small, at approximately 5, so the thickness of the capacitor dielectric film must be made thin under restrictions that concern the size of the area and complexity of shape that is required in order to expand the area when a large-capacity memory of less than 256 Mb is used, thus bringing much difficulty into the process.

Contrary to this, a perovskite crystal structure type of ferroelectric material containing a relatively large dielectric constant, from several 100 to several 1000, has been recognized as a future insulating material for capacitors in the dynamic RAM.

For forming a PZT film, referred to as $Pb(Zr, Ti)O_3$, among the ferroelectric materials, the sol gel method, CVD (chemical vapor-phase growth) method, and the sputtering method, for example, can be used as the method for forming thin films. Formation by the sol gel method is particularly preferable. When forming films by the sol gel method, the quality of the source solution (sol gel solution) prepared determines the electrical characteristics of the thin film obtained at the end.

The method for preparing the source solution (sol gel solution) used in the formation of the $Pb(Zr, Ti)O_3$ thin film by the sol gel method will be explained in Figure 18.

First, the hydrate lead triacetate $Pb(CH_3COC)_2 \cdot 3H_2O$ as the raw material is diluted with a solvent (methoxyethanol is often used in many cases, for example) in process 1.

The water of crystallization of the hydrate lead triacetate is successively eliminated through boiling at 120-160°C in process 2.

Next, titanium·isopropoxide $Ti\{(CH_3)_2CHO\}_4$ and zirconium·n-butoxide $Zr\{(CH_3(CH_2)_2CH_2O\}_4$ are added to said lead acetate solution in process 3. Diethanolamine may be added at the same time as a stabilizer.

The mixing concentration of each of the aforementioned elements is also indicated in Figure 18. The amount of methoxyethanol used as the solvent is adjusted in the preparatory stage of the source solution, so it is not indicated.

Next, a double alkoxide of titanium-lead and zirconium-lead is formed through distillation at 120-160°C in process 4. This double alkoxide is presumed to be formed in accordance with the reaction formula indicated below.

$$Pb(CH_3COO)_2 + Ti\{(CH_3)_2\ CHO\}_4$$

$$\rightarrow PbTiO_2\ \{OCH(CH_3)_2\}_2 + 2(CH_3)_2\ CHOCOCH_3$$

$$Pb(CH_3COO)_2 + Zr\{CH_3(CH_2)_2\ CH_2O\}_4$$

$$\rightarrow PbZrO_2\ \{OCH_2(CH_2)_2CH_3\}_2 + 2CH_3(CH_2)_2CH_2OCOCH_3$$

The concentration is successively adjusted in process 5 by supplementing for the solvent that was evaporated in process 4.

Furthermore, through adding water in process 6 and stirring in process 7, the double alkoxide formed in process 4 is allowed to undergo hydrolysis and a condensation reaction, then the aforementioned polymerization of the metallic oxides is promoted to prepare the sol gel solution. This process is presumed to advance in accordance with the reaction formula indicated below.

Hydrolysis (partial hydrolysis is assumed):

$$PbTiO_2\{(OCH(CH_3)_2\}_2 + H_2O$$

$\rightarrow PbTiO_2 \{OCH(CH_3)_2\} OH + (CH_3)_2 CHOH$

$PbZrO_2 \{OCH_2(CH_2)_2 CH_3\}_2 + H_2O$

$\rightarrow PbZrO_2 \{OCH_2(CH_2)_2CH_3\} OH + CH_3(CH_2)_2CH_2OH$

Condensation reaction (however, M represents Ti or Zr, and R is $-CH(CH_3)_2$ or $-CH_2(CH_2)_2 CH_3$):

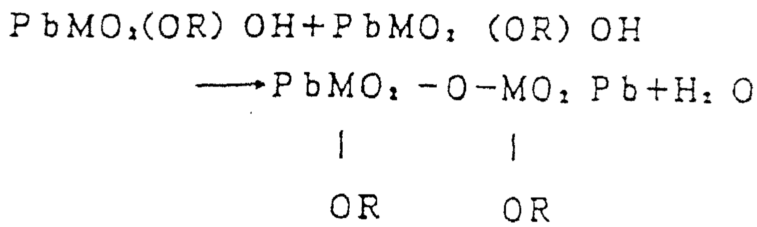

In this case, the actual polymerization occurs through the repeated advancing of hydrolysis and condensation of the double alkoxide in the following manner (however, R represents $-CH(CH_3)_2$ or $-CH_2(CH_2)_2CH_3$).

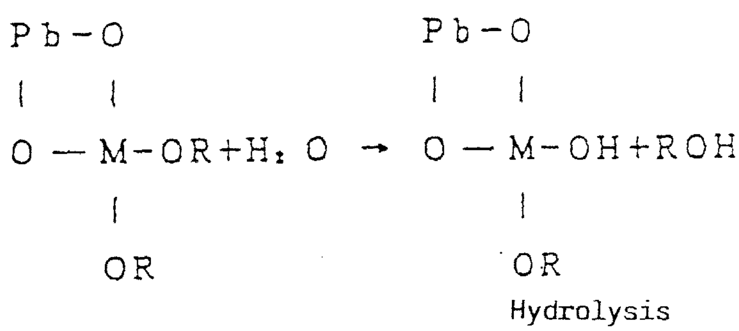


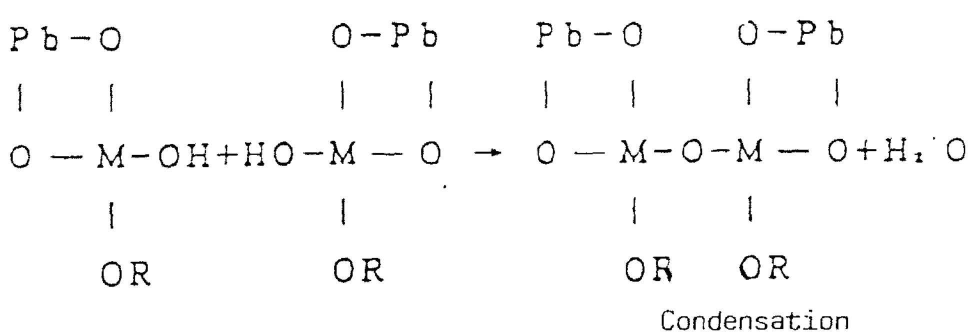


The characteristic of the PZT sol gel solution obtained in this manner is that the metallic oxides are polymerized through the hydrolysis and condensation in process 6 and process 7.

This sol gel solution (source solution) is then coated on top of a substrate by the spin-coating method or the dip-coating method, for example, dried at a temperature of 100-300°C, with the thin-coated sol gel film being changed into a dried gel condition (polymer gel).

Next, a thin sintered film of $Pb(Zr, Ti)O_3$ with a perovskite crystal structure -- the thin PZT Film -- is formed from the dry gel through an oxidation sintering process in a high-temperature oxidizing atmosphere of above 600°C.

However, it was confirmed that membrane formation is uneven when said thin PZT film is used as a dielectric

film in a capacitor, for example, in a memory cell, and the electrical resistance is small.

Through diligent examination for the objective of the invention, this inventor has discovered that the addition of titanium·isopropoxide and zirconium·n-butoxide to the lead acetate solution (methoxyethanol, for example, as the solvent) in the aforementioned process 3, and block distillation of these in the aforementioned process 4 for forming a double alkoxide, extends an adverse influence onto the polymerization of the alkoxide in processes 6 and 7 that follow.

More precisely, ea.ch of the double alkoxides:
$PbTiO_2\{OCH(CH_3)_2\}_2$ and $PbZrO_2\{OCH_2(CH_2)_2CH_3\}_2$ formed in process 4 has different alcohol residues (OR), so the hydrolysis and condensation in process 6 and process 7 do not uniformly advance, and different types of alcohol residues (OR) are mixed and present in the molecules formed in each of these reaction stages.

Such different alcohol residues, namely the isopropoxy group and the n-butoxy group, have a different reaction speed during hydrolysis and may react with other by-products in some cases. Therefore, it is highly possible that various types of molecular structures will be mixed and present in the condensation products formed, that structural separations will be caused, or various types of by-products will be formed.

Moreover, methoxyethanol used as the solvent also participates in the reaction in the manner below, so this solvent reacts with the alkoxide of process 3 during process 4 and mixes with the double alkoxide, further allowing the reaction to be nonuniform. This cannot be avoided even when the aforementioned alcohol residues (OR) are the same in both double alkoxides.

$$Ti\ \{(CH_3)_2CHO\}_4 + 4CH_3OC_2H_4OH$$

$$\rightarrow Ti\ (OCH_2H_4OCH_3)_4 + 4(CH_3)_2CHOH$$

$$Zr\ \{CH_3(CH_2)_2CH_2O\}_4 + 4CH_3OC_2H_4OH$$

$$\rightarrow Zr(OC_2H_4OCH_3)_4 + 4CH_3(CH_2)_2CH_2OH$$

$$Pb(CH_3COO)_2 + Ti(OC_2H_4OCH_3)_4$$

$$\rightarrow PbTiO_2(OC_2H_4OCH_3)_2 + 2CH_3OC_2H_4OCOCH_3$$

$$Pb(CH_3COO)_2 + Zr(OC_2H_4OCH_3)_4$$

$$\rightarrow PbZrO_2(OC_2H_4OCH_3)_2 + 2CH_3OC_2H_4OCOCH_3$$

As described above, with respect to the existing sol gel solution, reactions of the double alkoxide during the manufacturing process, and the polymerization reaction through hydrolysis and condensation afterwards, occur nonuniformly. Therefore, membranaceousness and electrical characteristics such as remanence, for example, of the thin PZT film formed, are easily insufficient and do not satisfy the performance demanded.

In US-A-4 946 710 a method to produce ferroelectric thin PZT films is disclosed. The method comprises a method of preparing a mixture suitable for spin deposition on substrates, comprising: solubilizing amounts of two or more precursors of lead, titanium (e.g. titanium alkoxide), and zirconium (e.g. zirconium alkoxide) in predetermined solvents said solvent being different for each precursor; mixing the metal precursors and solvents at a temperature sufficient to maintain the metal precursors in solution and for a period of time sufficient to produce a homogeneous mixture, adding an amount of water to the resulting solution sufficient to begin a hydrolysis reaction without causing precipitation of solids; and boiling the mixture at a temperature sufficient to vaporize said solvents and aziotrope water to increase the viscosity suitable for spin coating.

In THIRD EURO-CERAMICS, vol. 2, 12 September 1993, Spain pages 735 - 738, Pajewski et al. describe the use of PZT films prepared by the sol-gel process using hydrate lead acetate dissolved in glacial acetic acid, zirconium propoxide and titanium isopropoxide as precursors.

In JOURNAL OF THE ELECTROCHEMICAL SOCIETY, vol. 140, no. 9, September 1993, USA, pages 2640 - 2645 Vijay et al. describe sol-gel derived PZT films which were prepared from a metallorganic solution of lead acetate, zirconium n-propoxide, and titanium isopropoxide dissolved in acetic acid and n-propanol.

Problems to be solved by the invention

The aim of this invention is to provide: a method for forming a ferroelectric film having excellent membranaceousness and electrical characteristics as a result of uniform reactions during the preparatory processes for the sol gel solution, along with a satisfactory acceleration in the polymerization of the metallic oxides. It also concerns a method for manufacturing a capacitor using said film, as well as a method for preparing the source solution (sol gel solution), and the source solution itself.

Means for solving the problems

This inventor has elucidated the complicated reactions occurring during the aforementioned preparatory processes for the sol gel solution, has clarified the polymerization processes of a precursor of the metallic oxide (double alkoxide) by reviewing the processing conditions of the preparatory processes, and has established new preparatory processes.
This invention involves a method of preparing a PZT (lead zirconate titanate) sol gel solution for forming a ferroelectric film made from the precursors fatty acid lead compound, titanium alkoxide and zirconium alkoxide comprising the steps:

separately preparing solutions by diluting each of the precursors with an alcohol solvent; and
mixing said solutions;

characterized in that said solvent being the same for each precursor, and between the diluting steps and the mixing step the following steps are performed:

boiling the diluted titanium alkoxide at a temperature above the boiling point of the alcohol as an element of said titanium alkoxide, such that through alcohol exchange titanium alkoxide is formed;
boiling the diluted zirconium alkoxide at a temperature above the boiling point of the alcohol as an element of said zirconium alkoxide, such that through alcohol exchange zirconium alkoxide is formed having substantially the same alcohol residues as said titanium alkoxide formed through the alcohol exchange;

and in that after the mixing step the following step is performed:

boiling the mixture of the three solutions at a temperature above the boiling points of the alcohol of the aforementioned solvent and the ester derived from said fatty acid and said alcohol of the aforementioned solvent, such that lead titanium double alkoxide and lead zirconium double alkoxide are formed.

After forming said titanium lead·double alkoxide and zirconium lead·double alkoxide, ideally these reaction products are cooled to room temperature, the concentration is adjusted with the addition of the aforementioned alcohol, and hydrolysis and a condensation reaction are further provided for the aforementioned reaction products through the addition of water and stirring (stirring for 12-36 h above the boiling point of water, for example) in order to polymerize the aforementioned reaction products.
Precipitation of the products and formation of the by-products can be prevented by boiling the reaction solution at a temperature above 100°C after the polymerization of said reaction products.
A stabilizer consisting of an alkanolamine (diethanolamine, for example) and/or β-diketone (acetylacetone, for example) may be added in order to prevent the precipitation of the products at least during the process for forming the titanium lead·double alkoxide and zirconium lead·double alkoxide from each of the aforementioned processes. The amount added is preferably less than 1.0 times that of the total number of moles of the constitutive metals of the ferroelectric film.
Quaternary metallic elements such as lanthanum, niobium, and iron, for example, may be added during the forming process of the double alkoxide, for example, in the aforementioned processes in order to prevent fatigue (reduction in the remanence value) and a leakage of current through an inversion of the voltage applied when the formed thin PZT film is used.
After preparing the source solution (sol gel solution) through the aforementioned polymerization of the reaction products using the method in this invention, a ferroelectric film can be formed by coating this source, forming a dry film by drying this coated source solution, and sintering said dry film.
This invention also provides a method for manufacturing a capacitor (capacitor in a semiconductor memory device, for example) in which the ferroelectric film is formed by coating the aforementioned prepared source solution on top of an upper electrode, drying it, and sintering the obtained dry film, with the unnecessary portion of this film being eliminated and the ferroelectric film being left in a specific pattern on top of the aforementioned upper electrode,

and with an upper electrode being further formed on top of said ferroelectric film.

This invention also provides a method to prepare a source solution for the ferroelectric film through each of the aforementioned processes, and also provides the prepared source solution itself.

Brief explanation of the figures

Reference will now be made, by way of example to the accompanying drawings, in which :-

Figure 1 is a diagram that indicates the flow in a preparatory process of the source solution based on this invention.

Figure is a diagram that indicates the flow in a process for forming the thin PZT film by the sol gel method based on this invention.

Figure 3 is a diagram that indicates the C-V characteristics of the PZT film formed by the sol gel method using the source solution based on this invention.

Figure 4 is a diagram that indicates the hysteresis curves of the same PZT film due to the remanence.

Figure 5 is a diagram that indicates the I-V characteristics of the same PZT film.

Figure 6(A) indicates a diagram that is a schematic cross section in a condition in which the thin PZT film is formed on top of the substrate; (B) is a diagram that indicates a schematic diagonal view of the same rupture.

Figure 7 shows SEM pictures exhibiting the flat face of the thin PZT film based on this invention in the condition in Figure 6(B).

Figure 8 shows an SEM picture of a thin PZT film that is not based on this invention as in Figure 7.

Figure 9 is a diagram that indicates an enlarged cross section of one processing stage in the manufacturing method for a memory cell in dynamic RAM.

Figure 10 is a diagram that indicates an enlarged cross section of another processing stage in the manufacturing method for the same memory cell.

Figure 11 is a diagram that indicates an enlarged cross section of another processing stage in the manufacturing method for the same memory cell.

Figure 12 is a diagram that indicates an enlarged cross section of another processing stage in the manufacturing method for the same memory cell.

Figure 13 is a diagram that indicates an enlarged cross section of another processing stage in the manufacturing method for the same memory cell.

Figure 14 is a diagram that indicates an enlarged cross section of another processing stage in the manufacturing method for the same memory cell.

Figure 15 is a diagram that indicates an enlarged cross section of another processing stage in the manufacturing method for the same memory cell.

Figure 16 is a diagram that indicates an enlarged cross section of the same memory cell (diagram of a cross section at line XVI-XVI in Figure 17).

Figure 17 is a diagram that indicates an enlarged cross section of the same memory cell.

Figure 18 is a diagram that indicates the flow in the preparatory process for the source solution that is not based on this invention.

Application example

This invention will be explained in an application example below.

First, the method to prepare the source solution (sol gel solution) used for forming the thin PZT film indicated in a specific example will be explained according to Figure 1.

The main processes in the preparatory method for this source solution consist of: process I in which water of crystallization in the hydrate lead triacetate $Pb(CH_3COO)_2 \cdot 3H_2O$ is eliminated; processes II and III in which titanium·iso-propoxide $Ti\{(CH_3)_2CHO\}_4$ and zirconium·n-butoxide $Zr\{CH_3(CH_2)_2CH_2O\}_4$ are respectively provided with an alcohol exchange after being diluted with a solvent (methoxyethanol $CH_3OC_2H_4OH$); process IV in which a double alkoxide is formed and the by-products are eliminated at the same time; and processes VII and VIII in which polymerization through hydrolysis and the condensation reaction are accelerated. Each of the processes will be successively explained below.

Process I (Elimination of the water of crystallization)

The abbreviations of $[CH_3CO\text{-}]$ = Ac (acetyl group) and $[CH_3OC_2H_4\text{-}]$ = Rm (methoxylethyl group) will be used with the intention to simplify the chemical formulas. The water of crystallization in the hydrate lead triacetate Pb $(CH_3COO)_2 \cdot 3H_2O$ is eliminated in this process through heating above the boiling point of water, particularly at 120-180°C (160°C, for example) for 30 min to 2 h (1 h, for example).

$$Pb(OAc)_2 .3H_2O \rightarrow Pb(OAc)_2 + 3H_2O \uparrow \quad (1)$$

The following esterification takes place between the Ac groups and the Rm groups in succession to this elimination of the water of crystallization, and $Pb(ORm)_2$ (lead·methoxyethoxide) and RmOAc(methoxyethyl acetate) being formed.

$$Pb(OAc)_2 + 4RmOH \rightarrow Pb(ORm)_2 + 2RmOAc + 2H_2O \uparrow \quad (2)$$

In this case, the amount of RmOAc formed is approximately 6% of the total Ac number of moles, indicating the effective co-existence of $Pb(OAc)_2$ and $Pb(ORm)_2$ in the solution in process I.

Process II (preparation of the Ti solution)

An abbreviation of $[(CH_3)_2CH\text{-}] = R_p$ (isopropyl group) is used here. The solvent $CH_3OC_2H_4OH$ has a [-OH] (hydroxyl group) and performs an alcohol exchange between $Ti(OR_p)_4$ through boiling above the boiling point (82.5°C) of isopropyl alcohol $R_pOH$, particularly 70-190°C (160°C, for example), for 30 min to 2 h (1 h, for example).

$$Ti\ (OR_P)_4 + xRmOH \leftrightarrow Ti\ (OR_P)_{4\text{-}X}(ORm)_X + xR_P\ OH\uparrow \quad (3)$$

This equation (3) is an equilibrium reaction, therefore, the value of x differs according to each of the initial concentrations, and $Ti(ORm)_4$ can be obtained when x = 4.

Process III (preparation of the Zr solution)

An abbreviation of $[CH_3(CH_2)_2CH_2\text{-}] = R_b$ (n-butyl group) is used here. The solution $CH_3OC_2H_4OH$ has a [-OH] (hydroxyl group) and performs an alcohol exchange between $Zr(OR_b)_4$ through boiling above the boiling point (117.4°C) of n-butanol RbOH, particularly 70-190°C (160°C, for example), for 30 min to 2 h (1 h, for example).

$$Zr(OR_b)_4 + xRmOH \leftrightarrow Zr(OR_b)_{4\text{-}X}(ORm)_X + xR_b\ OH\uparrow \quad (4)$$

This equation (4) is an equilibrium reaction, so the value of x differs according to each of the initial concentrations, and $Zr(ORm)_4$ can be obtained when x = 4.

Process IV (mixing of the solutions, preparation of double alkoxide, and elimination of the by-products)

The solutions prepared in processes I, II, and III are mixed and the solvents $R_pOH$, $R_bOH$, and RmOAc are eliminated through heating and stirring (distillation) above the boiling point (143°C) of methoxyethyl acetate RmOAc, particularly 120-200°C (180°C, for example) for 3-10 h (6 h, for example). An elementary reaction formula for each solution is rearranged below.

$$\text{Process I : } Pb(OAc)_2 + 4\ RmOH \rightarrow Pb(ORm)_2 + 2\ RmOAc + 2H_2O \uparrow \quad (2)$$

$$\text{Process II : } Ti(OR_p)_4 + 4\ RmOH \rightarrow Ti(ORm)_4 + 4\ R_p\ OH \uparrow \quad (3)$$

$$\text{Process III : } Zr(OR_b)_4 + 4\ RmOH \rightarrow Zr(ORm)_4 + 4R_b\ OH \uparrow \quad (4)$$

The concentration of the solution (methoxyethanol RmOH as the solvent: boiling point 124°C) at each of said processes is as listed below.

0.01-2.0 mol/L as $Pb(OAc)_2$: $Pb(OAc)_2 \cdot 3H_2O$, 0.275 mol/L, for example (The Pb concentration is excessive)
$Ti(OR_p)_4$: 0.05-1.0 mol/L, 0.125 mol/L, for example
$Zr(OR_b)_4$: 0,05 - 1.0 mol/L, 0.125 mol/L, for example

The boiling points of the by-products here are as listed below.

$R_pOH$ (isopropyl alcohol) :bp = 82.5°C
$R_bOH$ (n-butanol) :bp = 117.4°C
RmOAc (methoxyethyl acetate) :bp = 143.0°C

As described above, the aforementioned elementary reactions (2) to (4) advance towards the right by eliminating $R_pOh$, $R_bOH$, and RmOAc through distillation at 180°C, for example. However, as described above, RmOAc during distillation is stabilized at approximately 6% of the total Ac number of moles. Therefore, most of the Pb during process I is $Pb(OAc)_2$, and a small amount of $Pb(ORm)_2$ coexists. The reactions continuously progress towards the right during processes II and III, and $Ti(ORm)_4$ and $Zr(ORm)_4$ are mainly formed.
The aforementioned reaction products react in the following manner in process IV, and double alkoxide $PbTiO_2(ORm)_2$ and $PbZrO_2(ORm)_2$ are formed.

$$Pb(OAc)_2 + Ti(ORm)_4 \rightarrow PbTiO_2\,(ORm)_2 + 2RmOAc \uparrow \quad (5)$$

$$Pb(OAc)_2 + Zr(ORm)_4 \rightarrow PbZrO_2\,(ORm)_2 + 2RmOAc \uparrow \quad (6)$$

The double alkoxide obtained in this manner consists of the structural formula below.

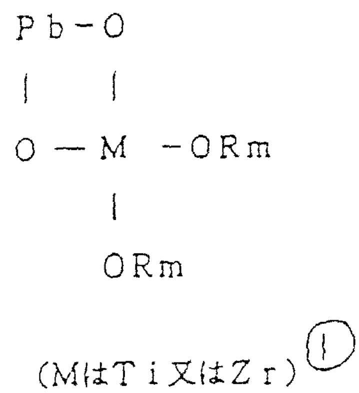


Key: 1 (M represents Ti or Zr)
The material remaining during this reaction after a distillation at 180°C, for example, consists mainly of the double alkoxide $PbMO_2(ORm)_2$; a small amount of $Pb(ORm)_2$ and RmOH is also present.

Process V (cooling)

The high-temperature double alkoxide solution obtained in process IV is first cooled to room temperature, and is shifted to process VI which follows.

Process VI (adjustment of the concentration)

The concentration of the double alkoxide increases according to the consumption or distillation of RmOH during the aforementioned process, so the solvent RmOH is added to dilute it to the desirable concentration.

Process VII (addition of water = hydrolysis)

Water at a number of moles that is the same as the total number of moles of metal of the solution is added

to the double alkoxide solution with an adjusted concentration to perform hydrolysis (however, RmOH may be further added).

More precisely, the aforementioned organometallic compound (double alkoxide) is formed as an intermediate product in the solution obtained through distillation during process IV, and the -ORm groups that are present in such material undergo hydrolysis when encountering $H_2O$, as indicated below, and are changed into [-OH] groups.

$$-ORm + H_2O \rightarrow -OH + RmOH$$

Furthermore, -OH condenses with other -OH, and the $H_2O$ formed here again contributes to hydrolysis.

$$-OH + HO- \rightarrow -O- + H_2O$$

Process VIII (stirring and polymerization of double alkoxide)

[-ORm] is transformed into [-OH] in the aforementioned reaction and polymerization further advances through condensation. This can be sufficiently attained through stirring, particularly above the boiling point of water (120°C, for example), for 12-36 h (24 h, for example) according to the reaction indicated below (M represents Ti or Zr).

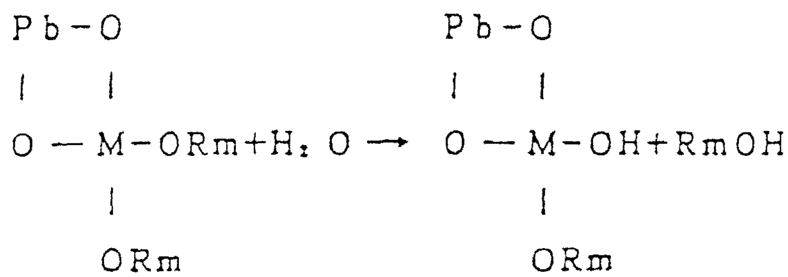
(7)

Hydrolysis

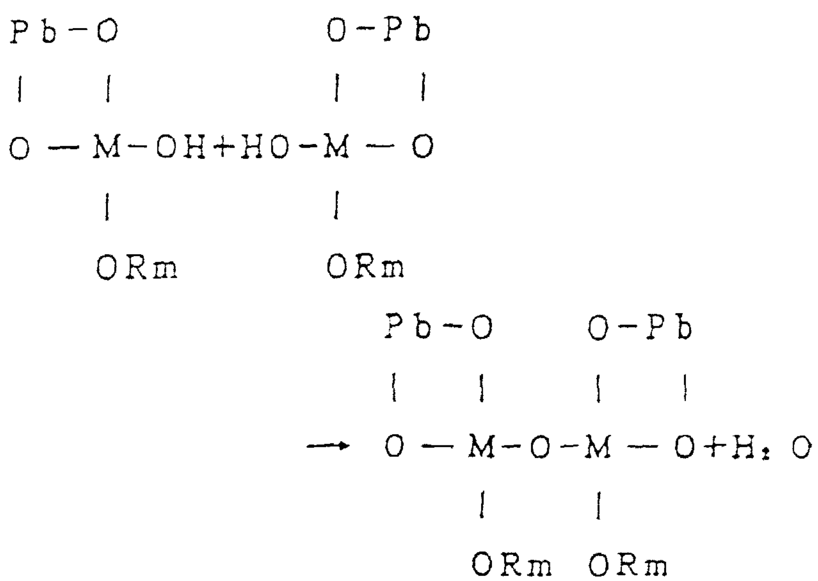
(8)

Condensation

The double alkoxide is polymerized as these reactions (7) and (8) successively advance. In this manner, a polymerized solution for the double alkoxide (metallic oxide) intended, which is a sol gel solution used to form the thin PZT film, can be obtained.

Next, polymerization of the aforementioned $Pb(ORm)_2$ (methoxyethoxide lead) that is formed as an intermediate product will be considered. First, [-ORm] is transformed into [-OH] as in the equation below through the aforementioned hydrolysis, condensation of [-OH] occurs in succession, and [-Pb-O-] is polymerized through repeating these reactions.

$$RmO\text{-}Pb\text{-}OH + HO\text{-}Pb\text{-}ORm \rightarrow RmO\text{-}Pb\text{-}O\text{-}Pb\text{-}ORm + H_2O \qquad (10)$$

As can be clearly observed in the explanation above, the preparatory method for the sol gel solution based on this invention is characterized by having the alcohol residue (ORm) for each of the reaction products titanium·alkoxide $Ti(ORm)_4$ and zirconium·alkoxide $Zr(ORm)_4$, particularly during the forming process (process IV) of the double alkoxide, already matched in processes II and III. That characteristic allows for a prominent interaction that could not be expected in the existing methods.

More precisely, hydrolysis and condensation advance uniformly (without a substantial difference in each of the double alkoxides) in processes VII and VIII because the alcohol residue (ORm) for each of the aforementioned double alkoxides formed in process IV is the same. Accordingly, the alcohol residue in the high-molecular-weight compound of metallic oxides obtained becomes uniform, the molecular structure becomes constant (without structural separation), and the types of by-products (RmOAc) are reduced for easy elimination.

Moreover, the same methoxyethanol (RmOH) is used as the solvent in all of the aforementioned processes I, II, and III, so the formation reaction and polymerization reaction of the aforementioned metallic alkoxide and double alkoxide advance uniformly through the participation of this solvent in the reaction, and the types of by-products (RmOAc, for example) are reduced for easy elimination.

With respect to the by-products, the processing temperature in processes II, III, and IV is established at above the boiling point of the by-products that are to be eliminated ($H_2O$, RmOAc, $R_pOH$, and $R_bOH$), so undesirable by-products can be sufficiently eliminated and the polymerization reaction of the metallic oxide that follows can be more uniformly attained.

Accordingly, a uniform formation reaction of the double alkoxide and a polymerization reaction through hydrolysis and condensation afterwards can be attained and by-products can be sufficiently eliminated with the sol gel solution prepared based on this invention. Therefore, intermolecular stress caused by the structural separation and decomposition of the organic groups can be lessened and defects in density such as pores, for example, can be reduced, and the thin PZT film formed has sufficient electrical characteristics such as the display of a smooth surface, a large remanence, and a small leakage of current, for example, thus satisfying the demands on performance.

Precipitation from the solution can be prevented by boiling the solution at a temperature higher than 100°C after completion of the aforementioned process VIII.

Quaternary metallic elements such as lanthanum, niobium, and iron, for example, may be added during the forming process of the double alkoxide, for example, among the aforementioned processes in order to prevent fatigue (reduction in the remanence value) and a leakage of current through an inversion of the voltage applied when the thin PZT film is being used.

Precipitation of the reaction products in the solution can be prevented by adding an alkanolamine (diethanolamine, for example) and/or β-diketone (acetylacetone, for example) as a stabilizer. It is possible to advance the reaction by adding an appropriate amount of this stabilizer at least in process IV (however, such an addition in processes II and III is not recommended if circumstances allow) among the aforementioned process II, process III, process IV, and process VIII. The amount added is recommended to be less than 1.0 times that of the total number of moles of metal of the constitutive elements of the ferroelectric film when the intention is to improve the performance of the thin PZT film (improvement of the remanence density, for example).

Diethanolamine $NH(C_2H_4OH)_2$, for example, that is mixed as the stabilizer has the function of preventing the precipitation of $M(OH)_n$ through the binding and formation of $\{NH(C_2H_4O\text{-})_2\}_nM$, and the polymerization of the metallic atoms that are bound with $NH(C_2H_4OH)_2$ does not advance further.

More precisely, the chemical equilibrium of Pb, which constitutes higher oxide polymers after condensation, and $H_2O$ remaining in the solution is indicated in the reaction formula of equation (11) below. $Pb(OH)_2$ is formed through this reaction, $NH(C_2H_4O\text{-})_2$ Pb is further formed in the reaction indicated in equation (12), and the condensation of [-Pb-O-] stops. This reaction product is released from the inside of the film through a tentative sintering during the formation of the thin PZT film which will be described later, so less problems occur. A similar reaction does not only occur with Pb, but can also be considered for Ti and Zr; it is thought that the reaction of Pb with a weak binding preferentially advances. Accordingly, $NH(C_2H_4OH)_2$ has the function of preventing precipitation by controlling hydrolysis, and has the function of controlling the polymerization of [-Pb-O-].

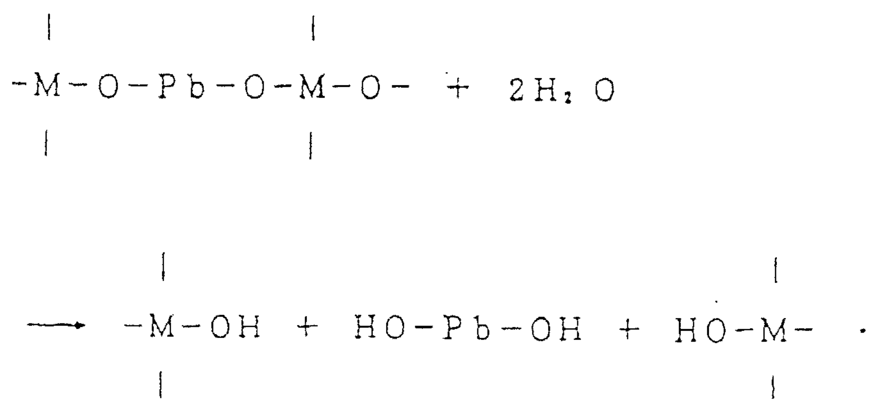

(11)

$$OH\text{-}Pb\text{-}OH + NH(C_2H_4OH)_2 \rightarrow NH(C_2H_4O\text{-})_2Pb + 2H_2O \quad (12)$$

A stabilizer such as diethanolamine, for example, can be added to a concentration of 0.25 mol/L, for example, but such an addition is not required when the aforementioned reaction ideally advances, and is in a condition in which precipitation does not occur (not forming $M(OH)_n$). However, diethanolamine at approximately 10% of the total number of moles of metal can be added after stirring in the aforementioned process VIII in order to prevent precipitation when formation is expected after a period of time due to moisture in the air.

$H_2O$ is eliminated and the progress of the aforementioned reaction (11) is prevented, which stops $M(OH)_n$ from being formed, when stirring in the aforementioned process VIII is performed above the boiling point of water, at approximately 120°C, for example.

Next, the method for forming the thin PZT film using the PZT sol gel solution prepared in the aforementioned processes will be described in Figure 2.

First, the sol gel solution obtained in the aforementioned preparatory processes (Figure 1) is coated over a Si substrate by the spin coat method (or the dip coat method) in process IX. A Pt film (thickness of 2000 Å) and a Ti film (thickness of 500 Å) in this order from the top, as a lower electrode, are formed on top of a $SiO_2$ film (thickness of 1000 Å) over the Si substrate by the sputtering method or the CVD method, with the aforementioned sol gel solution being coated upon the uppermost Pt film. The coating thickness when dried may be 2000 Å.

The substrate, onto which the sol gel solution is coated, is successively dried for 3 min, for example, over a heating block warmed to 100-300°C (170°C, for example) in process X, and a tentative sintering is provided for 10 min, for example, at above 600°C (650°C, for example) in process XI. After repeating process IX to process XI for an intended number of times, a permanent sintering is provided for 1 h, for example, at above 600°C (650°C, for example) in process XII.

A thin PZT film with a thickness of 2000 Å was obtained through said procedure. An Au upper electrode was formed by the sputtering method at the surface of the thin PZT film obtained; the electrical characteristics measured are indicated in Figures 3-5.

Figure 3 indicates C-V curves that are measured by the Quasistatic method (quasistatic C-V measuring method: dV/dt = 0.2 V/sec). The measurement voltage is established between ±1.65 V and ±4.0 V. The capacitance of the thin PZT film formed by the solution based on this invention increases together with the measurement voltage as indicated by the solid lines, displaying characteristic peculiar to the ferroelectric film.

Contrary to this, the capacitance of the thin PZT film formed with the existing solution (refer to Figure 18) is small as indicated by the broken lines, even when the measurement voltage is ±4.0 V.

Figure 4 indicates hysteresis curves that are determined by the C-V curves in Figure 3. The remanence value Pr of the thin PZT film based on this invention increases in proportion to the increase in the measurement voltage as indicated by the solid lines, and a value of 19.0-20.0 $\mu C/cm^2$ was obtained during a measurement at ±4 V. This remanence density is at the level that allows for the storage of a large amount of electrical charge of 380-400 $fc/\mu m^2$ when a capacitor in a nonvolatile memory, which will be described later, is prepared using the thin PZT film. This level far exceeds the 100 $fc/\mu m^2$ that is required. The resistance electrical field Ec is small and switching is easy.

Contrary to this, a remanence density of approximately only 10 $\mu C/cm^2$ was obtained with the existing thin PZT film as indicated by the broken lines even when the measuring voltage was ±4.0 V, and the resistance electrical field also increased.

Figure 5 indicates the I-V curve of the thin PZT film. A relatively small value of less than $10^{-8}$ $A/cm^2$ was obtained when a positive bias was applied to the upper Au electrode. This indicates that the leakage of current of the

thin film formed by the solution prepared based on this invention is substantially small while the commonly reported value is large at $10^{-6}$ A/cm$^2$.

As schematically indicated in Figure 6(A), a broken section, as shown in Figure 6(B), is produced by forming the aforementioned upper electrode (Pt/Ti) (6) on top of a silicon substrate (1), forming a thin PZT film (7) on the top, and rupturing at the position indicated by line A-A in Figure 6(A).

Figure 7 indicates SEM (scanning electron microscope) observed pictures of the surface of the thin PZT film based on this invention at the ruptured position. It can be observed that a smooth surface is formed with fine particles uniformly spread all over. It is thought that this brings about the aforementioned excellent characteristics.

Contrary to this, the growth of the grains of PZT is relatively large at the surface of the existing thin PZT film and the smoothness of the surface is lacking, thus becoming the cause for the aforementioned deterioration in characteristics.

Next, an example will be shown in which the thin PZT film, formed using the sol gel solution based on this invention, is used in a capacitor (stack type, for example) in a dynamic RAM memory cell, for example, which is a nonvolatile memory type.

First, an example of a dynamic RAM memory cell will be indicated in Figure 16 and Figure 17.

An element region separated by a field oxide film (2) is formed at one main face of a $P^-$type silicon substrate (1), for example, and to which a transfer gate TR, that consists of a MOS transistor and a memory cell M-CEL that consists of a capacitor CAP, are formed.

An $N^+$-type source region (3) and an $N^+$ type drain region (4), for example, are respectively formed through impurity diffusion at the transfer gate TR. A word line WL is formed through a gate oxide film (5) between these regions, with a bit line BL being connected to the drain region (4) through a contact hole (11) in insulation layers (9) and (10) such as $SiO_2$.

The capacitor CAP is referred to as a stack type. A lower electrode (6) is connected to the source region (3) through a contact hole (12) in the insulating layer (10); the PZT ferroelectric film (7) and an upper electrode (8) are successively laminated on top of said lower electrode.

The ferroelectric film (7), which contains the capacitor CAP, consists of PZT, which is the $Pb(Zr, Ti)O_3$ film formed by the sol gel method using the aforementioned source solution based on this invention. The lower electrode (6) consists of a tungsten layer or a titanium layer, for example, with Pt deposited, for example, on top (however, the indication of Pt, for example, is eliminated in the figure). The upper electrode (8) that makes contact with the ferroelectric film consists of Pt, Au, or aluminium, for example.

Next, the manufacturing method for this memory cell M-CEL will be explained in Figures 9-16.

First, as indicated in Figure 9, a field oxide film (2) is formed on top of a $P^-$-type silicon substrate (wafer) (1) by the selective oxidation process. A gate oxide film (5) and a polysilicon word line WL are respectively formed by the thermal oxidation method and the chemical gas-phase growth method. Furthermore, an $N^+$-type source region (3) and a drain region (4) are respectively formed through thermal diffusion of N-type impurities such as As.

A contact hole (12) is formed by photolithography at a $SiO_2$ insulating layer (10) that is deposited onto the entire surface by the chemical gas-phase growth method over a source region (3).

As indicated in Figure 10, a lower electrode (6), having a Pt layer on top of the tungsten or titanium layer, is successively formed in a manner such that it forms a junction with the source region (3) at the contact hole (12). This can be formed by providing a certain patterning to the tungsten or titanium layer or the Pt surface layer coated onto the entire surface by photolithography.

Next, as indicated in Figure 11, a sol gel source solution (17) is coated onto the entire surface including the lower electrode (6) by the spin coat method or the dip coat method. This source solution (17) has the same composition as the solution (refer to Figure 1) described above.

Next, the wafer coated with the source solution (17) is heated to a specific temperature (100-300°C, 170°C, for example) for 3 min, for example, the coated solution is dried, forming a dry gel film (27) as indicated in Figure 12.

Next, after drying is completed, the wafer is tentatively sintered at a temperature that forms the perovskite crystals (above 600°C, 650°C, for example) for 10 min. It is then permanently sintered (oxidation sintering) at above 600°C (650°C, for example) for 60 min, for example, after repeating the aforementioned drying, with a ferroelectric film (7) being formed onto the entire surface as indicated in Figure 13.

For forming the ferroelectric film (7) at a specific thickness (2000 Å, for example), dry film layers are laminated and the final film thickness can be obtained, without reaching the intended thickness all at once, through repeating the coating process in Figure 11, the drying process in Figure 12, and the aforementioned tentative sintering process as needed.

Next, as indicated in Figure 14, the unnecessary portion of the thin ferroelectric film (7) formed onto the entire surface is eliminated by the dry etching method, for example, and the thin PZT ferroelectric film (7) is formed in a specific pattern on top of the lower electrode (6).

Next, as indicated in Figure 15, an upper electrode (8) consisting of platinum, for example, is formed in a

specific pattern at the junction with the thin ferroelectric film (7) by photolithography.

Furthermore, interlayer insulating films (10) and (9), a contact hole (11), and a bit line BL are respectively formed by publicly known methods, and a memory cell indicated in Figure 16 is prepared.

The ferroelectric film (7) of the capacitor CAP in this memory cell is formed using the source solution based on this invention. Therefore, as described above, its film surface is flat, and the electrical characteristics consisting of a large remanence value and a small leakage of current can be obtained.

An application example of this invention was explained above, but the aforementioned application example can be further modified based on the technical concepts of this invention.

For example, instead of lead acetate, fatty acid lead compounds such as lead 2-ethylhexanoate and lead naphthenate can be used as a starting element for preparing the aforementioned sol gel source solution.

Instead of titanium·isopropoxide, titanium alkoxides such as titaniumtetraethoxide, titaniumtetra-n-butoxide, titanium-n-butoxide, and titanium-tetra-n-pentoxide can be used.

Instead of zirconium·n-butoxide, zirconium alkoxides such as zirconium·isopropoxide, zirconiumtetraethoxide, zirconium-tetra-n-butoxide, and zirconium-tetra-n-pentoxide can be used.

Each of these starting elements may be used as in one type or may be a combination of several types.

The boiling temperature of each of the dilute alkoxide solutions in the aforementioned processes II and III may be established as mentioned below because the boiling point of isopropyl alcohol is 82.5°C, the boiling point of n-butanol is 98-100°C, and the boiling point of ethyl alcohol is 78.3°C.

Ti-i-propoxide: 80-190°C
Ti-n-butoxide: 90-190°C
Ti-tetraethoxide: 70-190°C
Zr-i-propoxide: 80-190°C
Zr-n-butoxide: 90-190°C
Zr-tetraethoxide: 70-190°C

Accordingly, the temperature of the thermal process in the aforementioned processes II to III, the aforementioned process I, and the aforementioned process IV can be established at 70-190°C, 120-180°C, and 120-200°C, respectively.

Instead of methoxyethanol, n-propanol, isopropanol, or n-butanol, for example, can be used as the solvent.

Instead of diethanolamine, alkanolamines such as dipropanolamine and triethanolamine or β-diketones such as acetylacetone, applied jointly, can be used as the stabilizer.

The composition of the ferroelectric substance that can be obtained in this invention may be varied. Also, the application is not limited only to the stack-type capacitors. A structure may be used in which the aforementioned stack-type capacitor is formed on top of a $SiO_2$ film and the lower electrode of said capacitor is extended and connected to the source region of the transfer gate. It can also be applied in a capacitor that is not a stack type, but has a structure in which the capacitor is integrated within a so-called trench (groove).

Results of the function of the invention

As described above in this invention, for forming a ferroelectric film consisting of lead zirconate titanate using the sol gel method;

a process (a) for obtaining fatty acid lead compound,
a process (b) for obtaining titanium·alkoxide,
a process (c) for obtaining zirconium·alkoxide having the same alcohol residues as said titanium·alkoxide,
and a process (d) for forming lead titanium·double alkoxide and lead zirconium·double alkoxide by mixing the aforementioned fatty acid lead compound, the aforementioned titanium·alkoxide, and the aforementioned zirconium·alkoxide, are respectively performed, so that the hydrolysis and condensation that follow will advance uniformly (without a substantial difference in each of the double alkoxides) because the alcohol residue for each of the aforementioned double alkoxides formed in process (d) is the same.

Accordingly, the alcohol residue in the obtained high-molecular-weight compound of metallic oxides becomes uniform, the molecular structure becomes constant (without structural separation), and the types of by-products are reduced for easy elimination.

As a result, the intermolecular stress caused by structural separation and decomposition of the organic groups in the high polymer compound obtained can be reduced and density defects such as pores can be reduced. Thus, the thin PZT film formed from this sol gel solution has sufficient electrical characteristics such as the display of a smooth

surface, a large remanence, and a small leakage of current, for example, and satisfies the demanded performance.

## Claims

1. A method of preparing a PZT (lead zirconate titanate) sol gel solution for forming a ferroelectric film made from the precursors fatty acid lead compound, titanium alkoxide and zirconium alkoxide comprising the steps:

   separately preparing solutions by diluting each of the precursors with an alcohol solvent; and
   mixing said solutions;

   characterized in that said solvent being the same for each precursor, and between the diluting steps and the mixing step the following steps are performed:

   boiling the diluted titanium alkoxide at a temperature above the boiling point of the alcohol as an element of said titanium alkoxide, such that through alcohol exchange titanium alkoxide is formed;
   boiling the diluted zirconium alkoxide at a temperature above the boiling point of the alcohol as an element of said zirconium alkoxide, such that through alcohol exchange zirconium alkoxide is formed having substantially the same alcohol residues as said titanium alkoxide formed through the alcohol exchange;

   and in that after the mixing step the following step is performed:

   boiling the mixture of the three solutions at a temperature above the boiling points of the alcohol of the aforementioned solvent and the ester derived from said fatty acid and said alcohol of the aforementioned solvent, such that lead titanium double alkoxide and lead zirconium double alkoxide are formed.

2. The method described in claim 1 wherein the preparing step further comprises the step of diluting a hydrate fatty acid lead compound with said alcohol solvent and boiling the solution, such that the water of crystallization is eliminated.

3. The method described in any of claims 1 - 2, further comprising adding quaternary metallic elements such as lanthanum, niobium, and iron during the forming process of said double alkoxides.

4. The method described in any of claims 1 - 3, further comprising hydrolysing the reaction products through the addition of water, and polymerizing the reaction products through a condensation reaction.

5. The method described in claim 4, wherein prior to the hydrolysing step the reaction products are cooled to room temperature and the concentration with the addition of an alcohol solvent is adjusted and stirring is performed during the hydrolysing step.

6. The method described in any of claims 1 - 5, further comprising polymerizing the reaction products by stirring them at a temperature above the boiling point of water, such that a source solution is provided.

7. The method of claim 6, further comprising boiling the reaction solution at a temperature above 100°C after polymerization of the reaction products.

8. The method described in any of claims 1 to 7, further comprising adding a stabilizer consisting of an alkanolamine and/or a β-diketone wherein the amount of said addition is less than 1.0 times that of the total number of moles of metal for the constitutive metals of the ferroelectric film at least in the formation process of the lead titanium double alkoxide and the lead zirconium double alkoxide.

9. A method of forming a ferroelectric film comprising:

   preparing a source solution according to any of claims 4 to 7 or claim 8 depending on either claim 6 or 7;
   coating said source solution;
   forming a dry film by drying said coated source solution; and
   sintering said dry film.

**10.** A method of forming a capacitor comprising:

forming a ferroelectric film on top of the lower electrode according to claim 9;
eliminating the unnecessary portion of said film and leaving the ferroelectric film in a specific pattern on top of the aforementioned lower electrode; and
forming an upper electrode on top of said ferroelectric film.

**11.** The method described in claim 10 for manufacturing a capacitor in a semiconductor memory device.

**Patentansprüche**

**1.** Verfahren zum Herstellen einer PZT-(Bleizirconattitanat)-Sol-Gel-Lösung zum Bilden eines ferroelektrischen Films, der aus den Ausgangsstoffen einer Fettsäurebleiverbindung, Titanalkoholat und Zirconiumalkoholat besteht, mit den Schritten:

getrenntes Herstellen von Lösungen durch Verdünnen jedes der Ausgangsstoffe mit einem Alkohollösungsmittel und
Mischen der Lösungen,

dadurch gekennzeichnet, daß das Lösungsmittel für jeden Ausgangsstoff gleich ist und daß zwischen den Verdünnungsschritten und dem Mischschritt die folgenden Schritte ausgeführt werden:

Kochen des verdünnten Titanalkoholats bei einer Temperatur oberhalb des Siedepunkts des Alkohols als einem Element des Titanalkoholats, so daß durch Alkoholaustausch Titanalkoholat gebildet wird,
Kochen des verdünnten Zirconiumalkoholats bei einer Temperatur oberhalb des Siedepunkts des Alkohols als einem Element des Zirconiumalkoholats, so daß durch Alkoholaustausch Zirconiumalkoholat gebildet wird, das im wesentlichen die gleichen Alkoholreste aufweist wie das durch den Alkoholaustausch gebildete Titanalkoholat,

und daß nach dem Mischschritt der folgende Schritt ausgeführt wird:

Kochen der Mischung der drei Lösungen bei einer Temperatur oberhalb der Siedepunkte des Alkohols des erwähnten Lösungsmittels und des von der Fettsäure und dem Alkohol des erwähnten Lösungsmittels abgeleiteten Esters, so daß Bleititandoppelalkoholat und Bleizirconiumdoppelalkoholat gebildet werden.

**2.** Verfahren nach Anspruch 1, bei welchem der Herstellungsschritt weiter den Schritt des Verdünnens einer hydratisierten Fettsäurebleiverbindung mit dem Alkohollösungsmittel und des Kochens der Lösung, so daß das Kristallwasser beseitigt wird, beinhaltet.

**3.** Verfahren nach einem der Ansprüche 1 - 2, welches weiter das Hinzufügen quaternärer metallischer Elemente in der Art von Lanthan, Niob und Eisen während des Prozesses des Bildens der Doppelalkoholate beinhaltet.

**4.** Verfahren nach einem der Ansprüche 1 - 3, welches weiter das Hydrolysieren der Reaktionsprodukte durch das Hinzufügen von Wasser und das Polymerisieren der Reaktionsprodukte durch eine Kondensationsreaktion beinhaltet.

**5.** Verfahren nach Anspruch 4, bei welchem vor dem Hydrolysierschritt die Reaktionsprodukte auf die Raumtemperatur gekühlt werden und während des Hydrolysierschritts die Konzentration durch das Hinzufügen eines Alkohollösungsmittels eingestellt wird und währenddessen gerührt wird.

**6.** Verfahren nach einem der Ansprüche 1 - 5, welches weiter das Polymerisieren der Reaktionsprodukte durch Rühren bei einer Temperatur oberhalb des Siedepunkts von Wasser beinhaltet, so daß eine Ausgangslösung bereitgestellt wird.

**7.** Verfahren nach Anspruch 6, welches weiter das Kochen der Reaktionslösung bei einer Temperatur oberhalb von 100 °C nach der Polymerisation der Reaktionsprodukte beinhaltet.

**8.** Verfahren nach einem der Ansprüche 1 bis 7, welches weiter das Hinzufügen eines Stabilisators beinhaltet, der aus einem Alkanolamin und/oder einem β-Diketon besteht, wobei wenigstens beim Prozeß des Bildens des Bleititandoppelalkoholats und des Bleizirconiumdoppelalkoholats die hinzugefügte Menge kleiner ist als das 1,0fache der Gesamtzahl der Mole an Metall für die den ferroelektrischen Film bildenden Filme.

**9.** Verfahren zum Bilden eines ferroelektrischen Films, welches beinhaltet:

Herstellen einer Ausgangslösung nach einem der Ansprüche 4 bis 7 oder Anspruch 8, abhängig von Anspruch 6 oder 7,
Aufbringen der Ausgangslösung,
Bilden eines trockenen Films durch Trocknen der aufgebrachten Ausgangslösung und
Sintern des trockenen Films.

**10.** Verfahren zum Bilden eines Kondensators, welches beinhaltet:

Bilden eines ferroelektrischen Films auf der unteren Elektrode nach Anspruch 9,
Beseitigen des nicht erforderlichen Abschnitts des Films und Belassen des ferroelektrischen Films in einem speziellen Muster auf der erwähnten unteren Elektrode und
Bilden einer oberen Elektrode auf dem ferroelektrischen Film.

**11.** Verfahren nach Anspruch 10 zum Herstellen eines Kondensators in einem Halbleiter-Speicherbauelement.

**Revendications**

**1.** Procédé de préparation d'une solution gélifiée-sol de zirconate-titanate de plomb (PZT) pour former un film ferroélectrique à partir d'un composé du plomb et d'acide gras, d'un alcoolate de titane et d'un alcoolate de zirconium précurseurs, comprenant les étapes consistant :

à préparer séparément des solutions en diluant chacun des précurseurs avec un solvant alcoolique ; et
à mélanger lesdites solutions ;

caractérisé en ce que ledit solvant est le même pour chaque précurseur, et en ce qu'entre les étapes de dilution et l'étape de mélange, on effectue les étapes suivantes :

une ébullition de l'alcoolate de titane dilué à une température supérieure au point d'ébullition de l'alcool qui est un constituant dudit alcoolate de titane, de façon à former un alcoolate de titane par échange d'alcool ;
une ébullition de l'alcoolate de zirconium dilué à une température supérieure au point d'ébullition de l'alcool qui est un constituant dudit alcoolate de zirconium, de façon à former un alcoolate de zirconium par échange d'alcool, comportant à peu près les mêmes résidus d'alcool que ledit alcoolate de titane formé par échange d'alcool ; et

en ce qu'après l'étape de mélange, on effectue l'étape suivante :

une ébullition du mélange des trois solutions à une température supérieure aux points d'ébullition de l'alcool du solvant mentionné ci-dessus, et de l'ester dérivé dudit acide gras et dudit alcool du solvant mentionné ci-dessus, de façon à former un alcoolate double de plomb et de titanate et un alcoolate double de plomb et de zirconium.

**2.** Procédé selon la revendication 1, dans lequel l'étape de préparation comprend en outre l'étape de dilution d'un composé hydraté du plomb et d'un acide gras, avec ledit solvant alcoolique, et d'ébullition de la solution de façon à éliminer l'eau de cristallisation.

**3.** Procédé selon l'une quelconque des revendications 1 et 2, comprenant en outre une addition d'éléments métalliques quaternaires tels que le lanthane, le niobium, et le fer au cours du processus de formation desdits alcoolates doubles.

**4.** Procédé selon l'une quelconque des revendications 1 à 3, comprenant en outre une hydrolyse des produits de

réaction par addition d'eau, et une polymérisation des produits de réaction par réaction de condensation.

5. Procédé selon la revendication 4, dans lequel avant l'étape d'hydrolyse, les produits de réaction sont refroidis à la température ambiante, et la concentration est ajustée avec l'addition d'un solvant alcoolique, et on effectue une agitation au cours de l'opération d'hydrolyse.

6. Procédé selon l'une quelconque des revendications 1 à 5, comprenant en outre une polymérisation des produits de réaction par agitation de ceux-ci à une température supérieure au point d'ébullition de l'eau, de sorte que l'on obtient une solution source.

7. Procédé selon la revendication 6, comprenant en outre une ébullition de la solution réactionnelle à une température supérieure à 100 °C après polymérisation des produits de réaction.

8. Procédé selon l'une quelconque des revendications 1 à 7, comprenant en outre une addition d'un stabilisant consistant en une alcanolamine et/ou une β-dicétone, la proportion de ladite addition étant inférieure à 1,0 fois celle du nombre total de moles de métal des métaux constitutifs du film ferroélectrique, au moins dans le processus de formation de l'alcoolate double de plomb et de titane et de l'alcoolate double de plomb et de zirconium.

9. Procédé de formation d'un film ferroélectrique, comprenant :

   la préparation d'une solution source selon l'une quelconque des revendications 4 à 7 ou la revendication 8 dépendant de la revendication 6 ou 7 ;
   le dépôt de ladite solution source ;
   la formation d'un film sec par séchage de ladite solution source déposée ; et
   le frittage dudit film sec.

10. Procédé de formation d'un condensateur comprenant :

   la formation d'un film ferroélectrique au-dessus de l'électrode inférieure selon la revendication 9 ;
   l'élimination de la partie inutile dudit film, et le maintien du film ferroélectrique selon un dessin spécifique au-dessus de l'électrode inférieure mentionnée ci-dessus ; et
   la formation d'une électrode supérieure au-dessus dudit film ferroélectrique.

11. Procédé selon la revendication 10 pour la fabrication d'un condensateur dans un dispositif de mémorisation à semi-conducteur.

FIG. 1

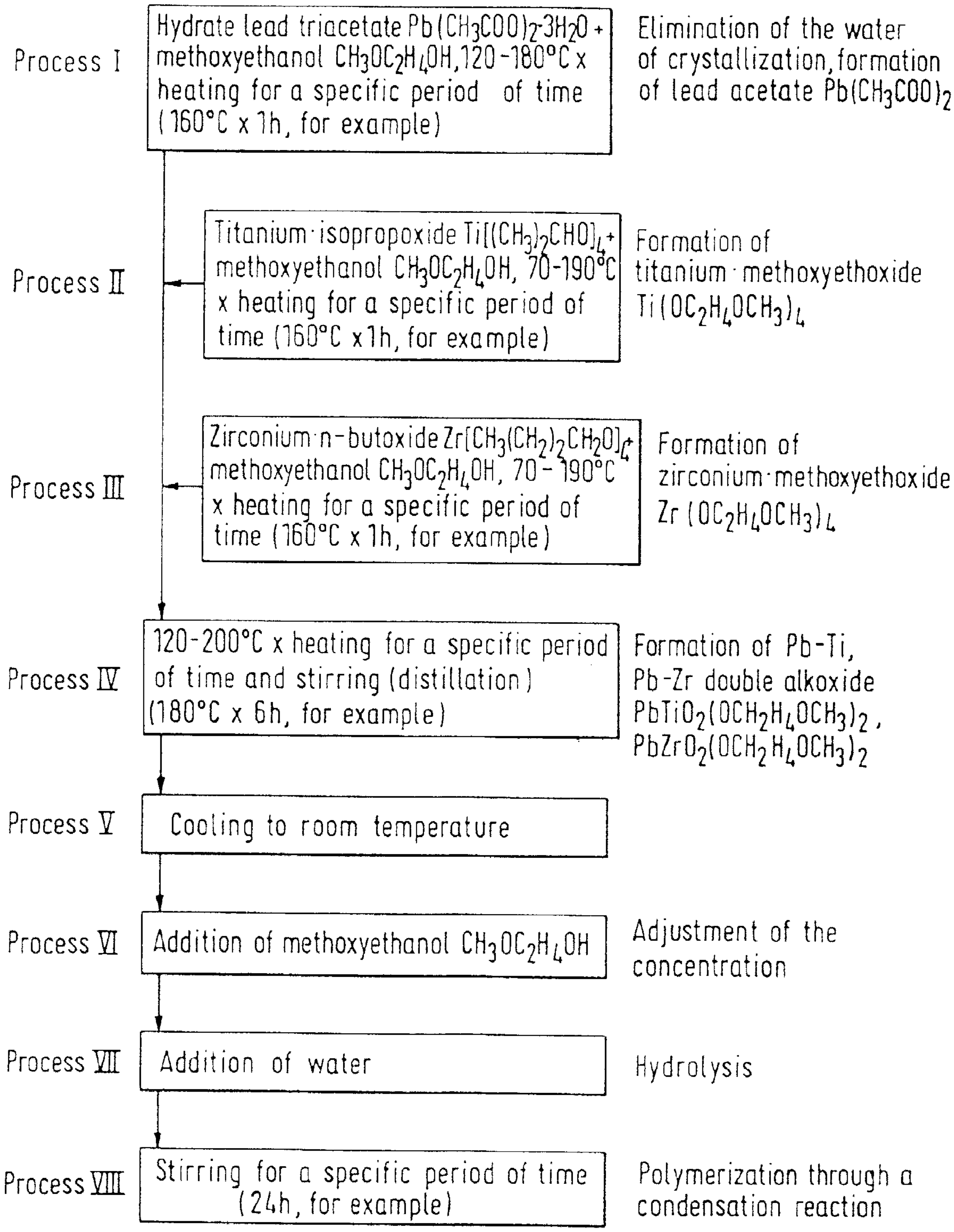


Flow in the preparatory process for the PZT sol gel solution

FIG. 2

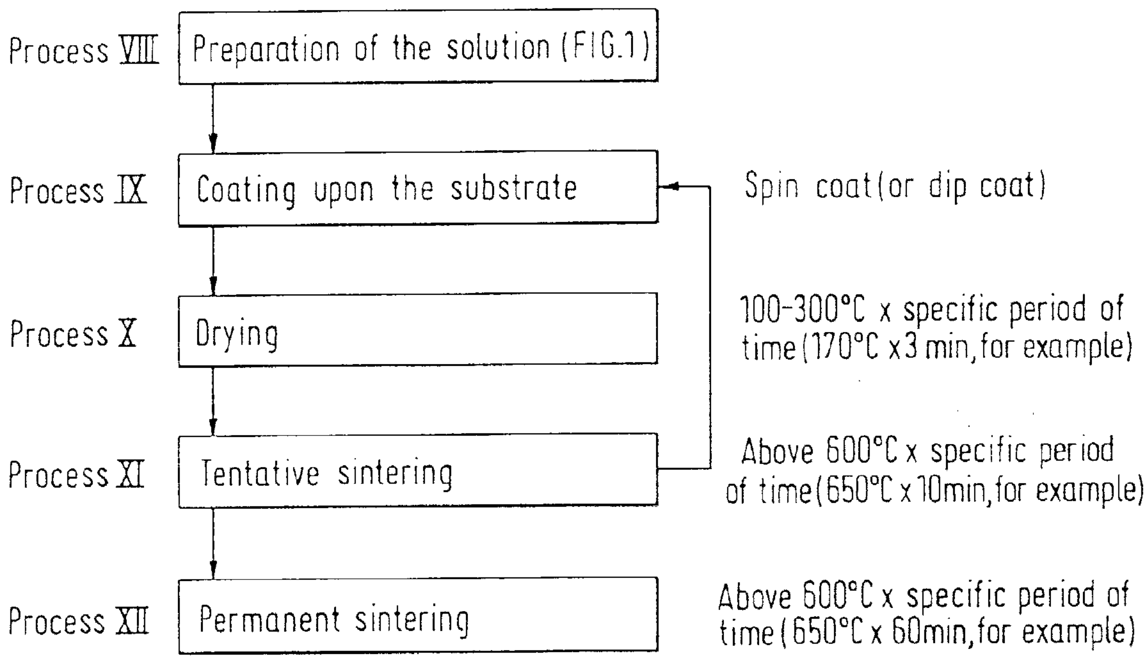


Flow in the forming process for the PZT film

FIG. 3

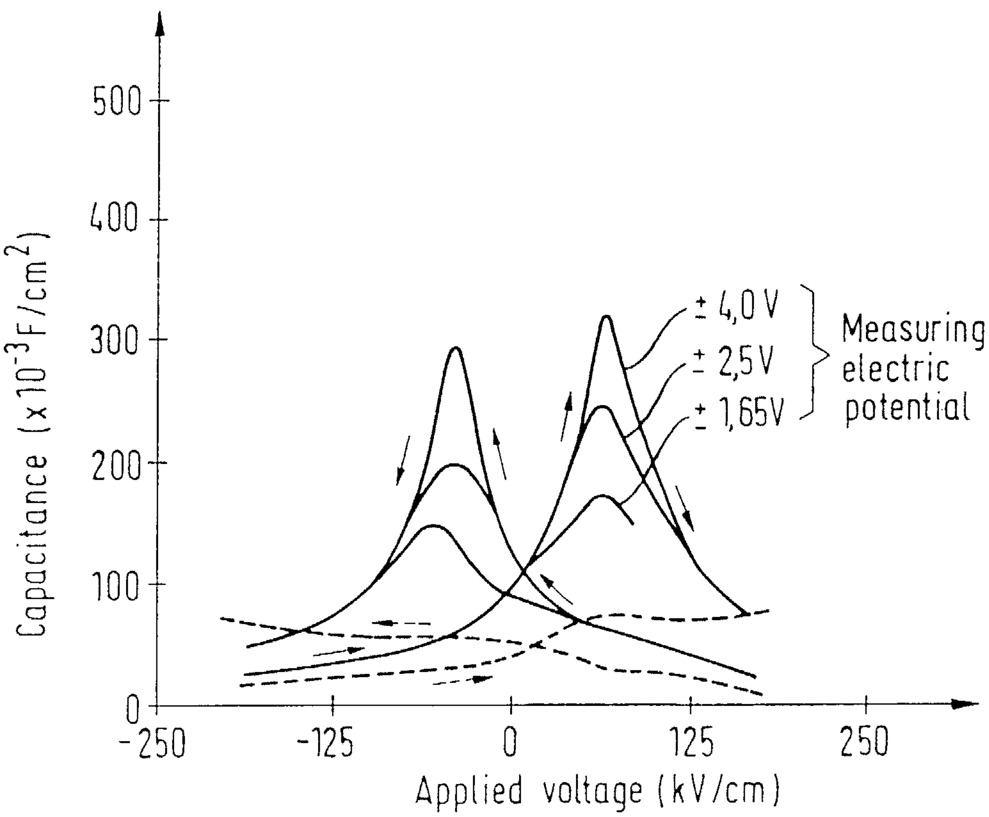


Quasistatic C-V characteristics of the PZT film (thickness of 200nm) by the applied voltage

FIG. 4

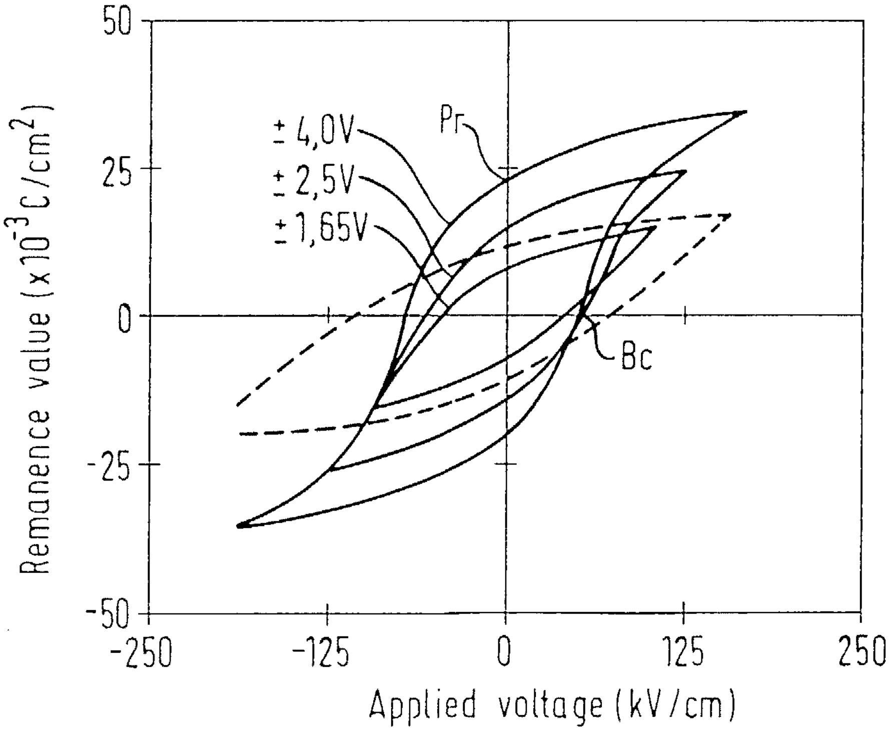


Hysteresis curves of the PZT film (thickness of 200nm) by the applied voltage

FIG. 5

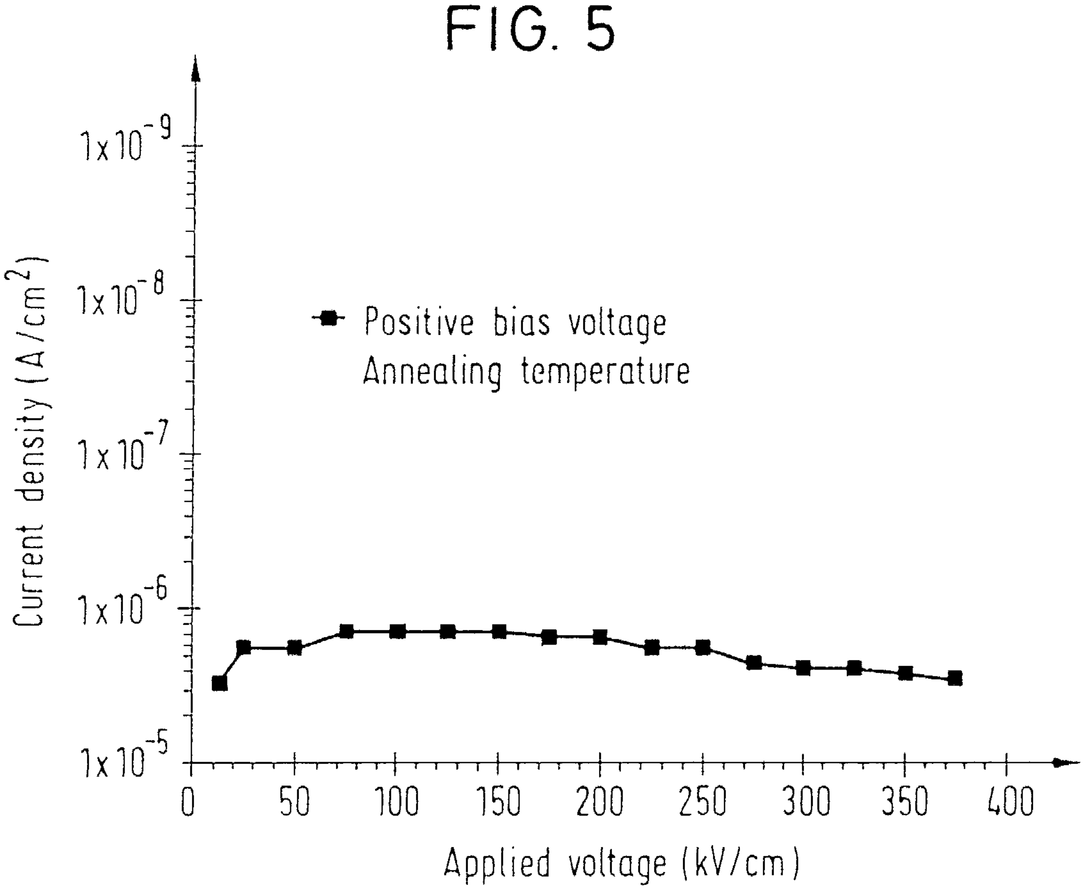


I-V characteristic of the PZT film (thickness of 200nm and an Au electrode attached) by the applied voltage

FIG. 6

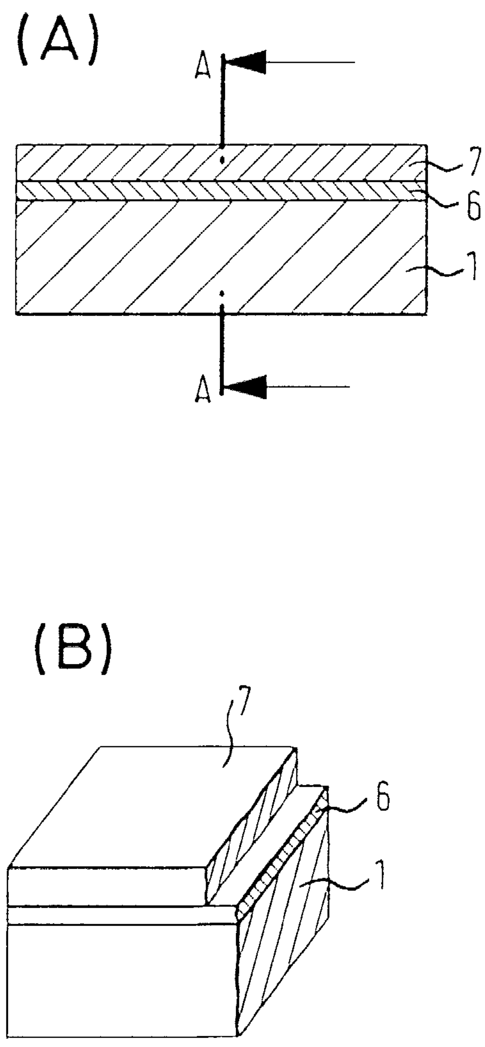

FIG. 7

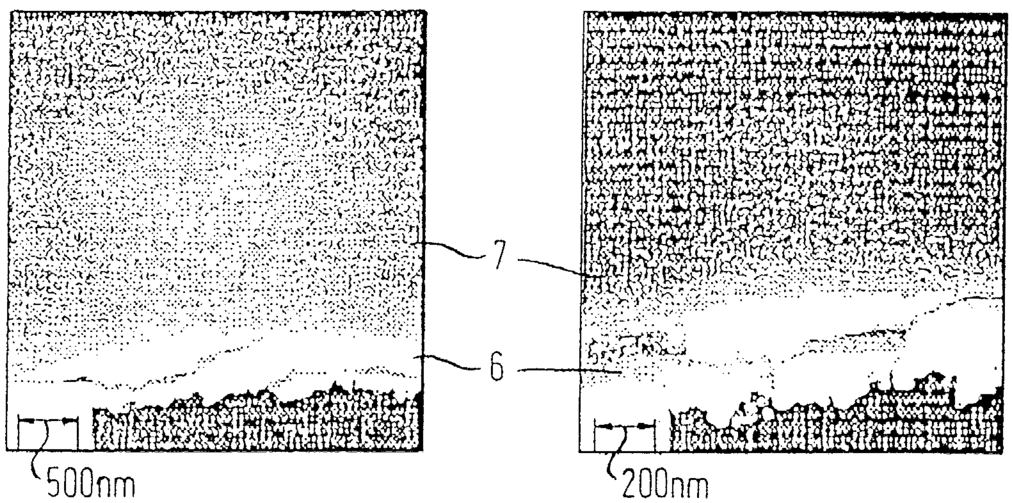


SEM observed pictures of the surface of the PZT film

FIG. 8

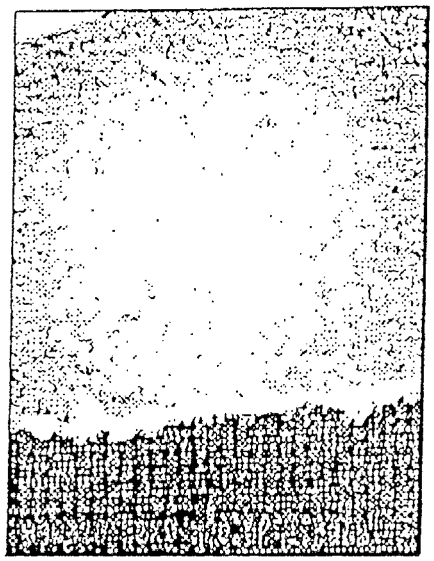

(1500nm)
x 20,000

A SEM observed picture of the surface of the PZT film

FIG. 9

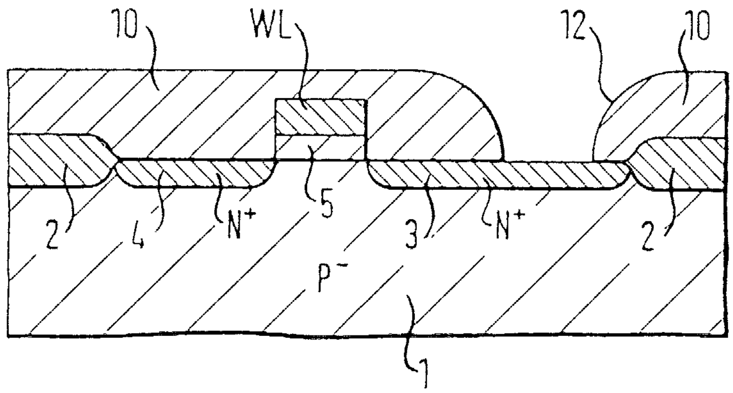


FIG. 10

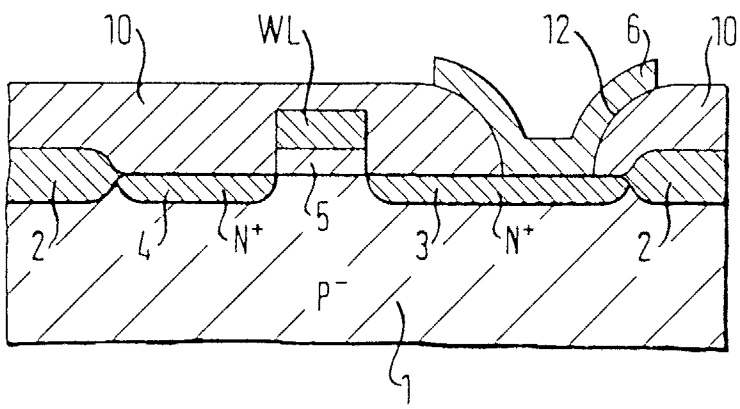

FIG. 11

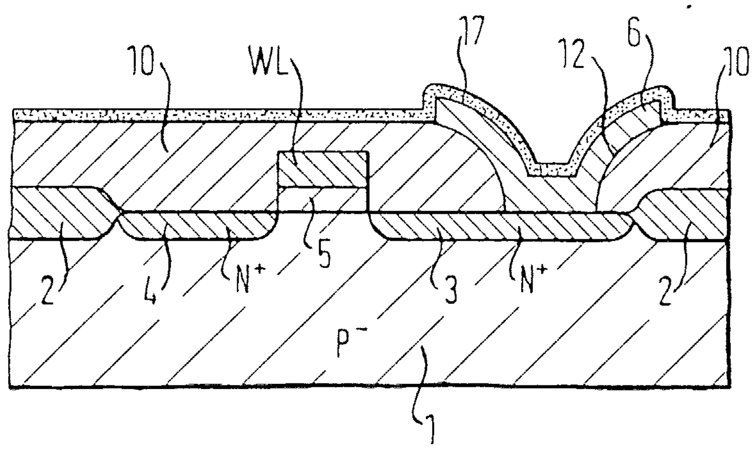


FIG. 12

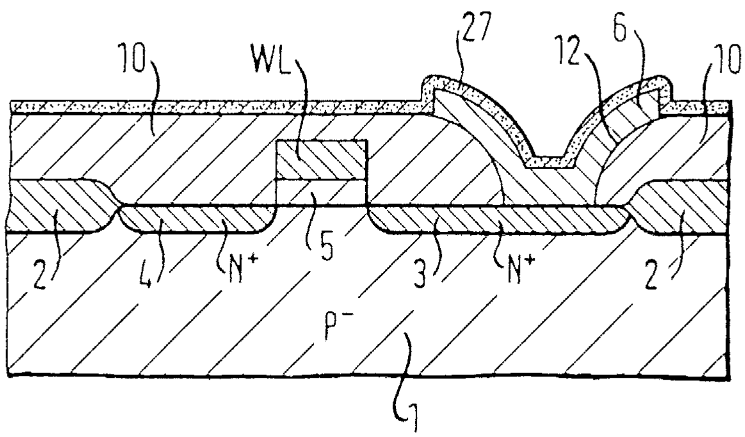

FIG. 13

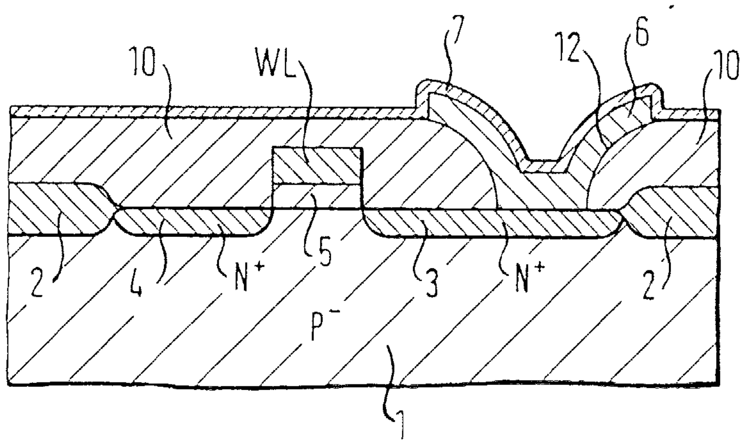


FIG. 14

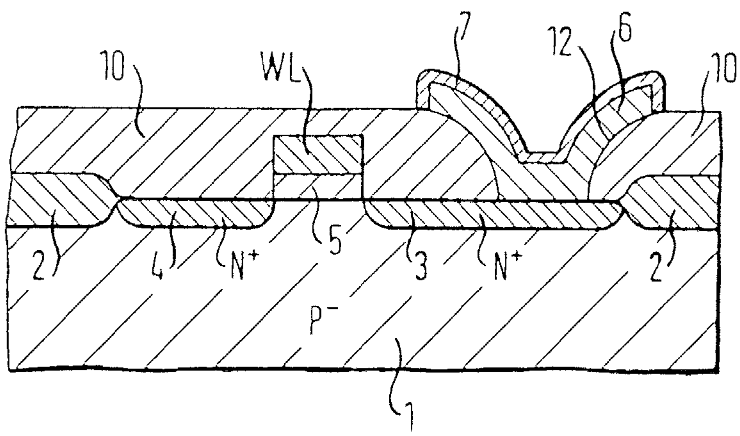

FIG. 15

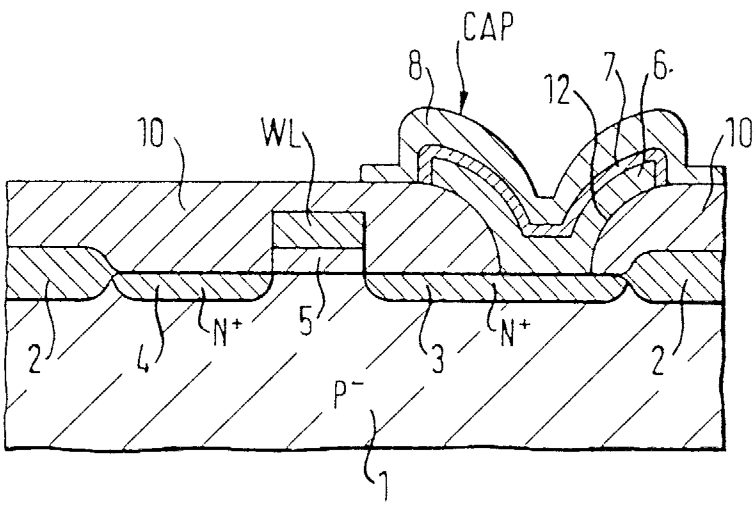
CAP
8
12
7
6
10
WL
10
2
4
N+
5
3
N+
2
P−
1

FIG. 16

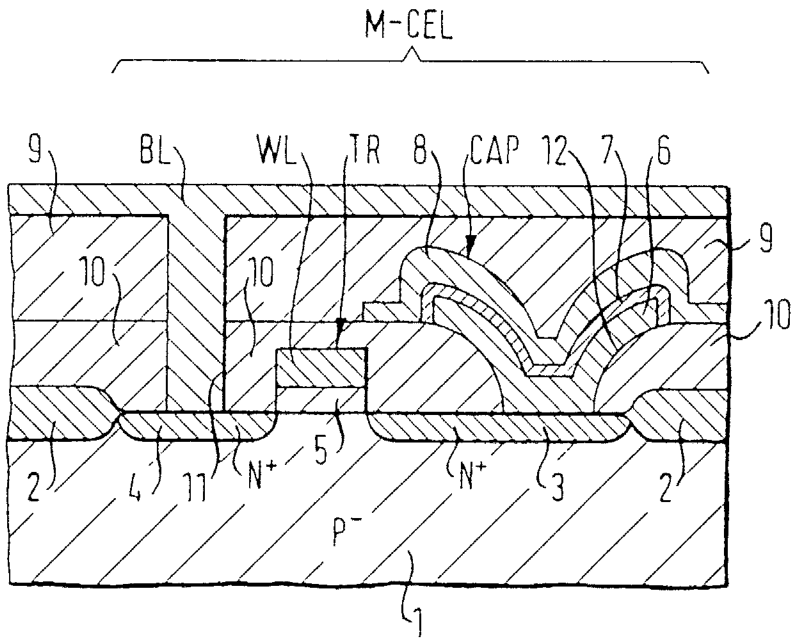
M-CEL
9
BL
WL
TR
8
CAP
12
7
6
9
10
10
10
2
4
11
N+
5
N+
3
2
P−
1

FIG. 17

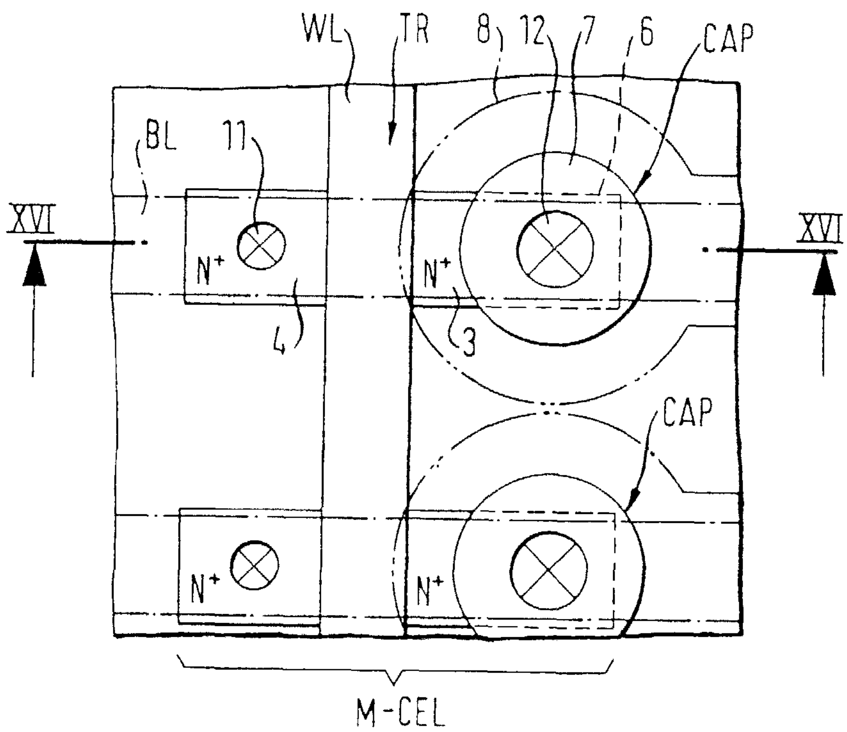

FIG. 18

| Process | Step | Purpose |
| --- | --- | --- |
| Process 1 | Dilution of hydrate lead triacetate $Pb(CH_3COO)_2 \cdot 3H_2O$ with the solvent | |
| Process 2 | Elimination of the water of crystallization at 120-160°C | Elimination of the water of crystallization |
| Process 3 | Addition of titanium·isopropoxide $Ti[(CH_3)_2CHO]_4$ and addition of zirconium·n-butoxide $Zr[CH_3(CH_2)_2CH_2O]_4$ | |
| Process 4 | Distillation at 120-160°C | Formation of Pb-Ti, Pb-Zr double alkoxide |
| Process 5 | Addition of the solvent | Adjustment of the concentration |
| Process 6 | Addition of water | Hydrolysis |
| Process 7 | Stirring | Polymerization through a condensation reaction |

Flow in the preparatory process for a common PZT sol gel solution

Material for the PZT sol gel solution

| Material | Chemical formula of the material | Mixing concentration |
| --- | --- | --- |
| Lead triacetate hydrate | $Pb(CH_3COO)_2 \cdot 3H_2O$ | 0,275 mol / l |
| Titanium·isopropoxide | $Ti[(CH_3)_2CHO]_4$ | 0,125 mol / l |
| Zirconium·n-butoxide | $Zr[CH_3(CH_2)_2CH_2O]_4$ | 0 125 mol / l |
| Diethanolamine (stabilizer) | $NH(CH_2CH_2OH)_2$ | 0,525 mol / l |
| Methoxyethanol (solvent) | $CH_3OC_2H_4OH$ | — |